(19)

Europäisches
Patentamt

European
Patent Office

Office européen
des brevets

(11) **EP 3 121 246 A1**

(12) **EUROPEAN PATENT APPLICATION**
published in accordance with Art. 153(4) EPC

(43) Date of publication:
**25.01.2017 Bulletin 2017/04**

(21) Application number: **15764131.7**

(22) Date of filing: **18.03.2015**

(51) Int Cl.:
*C09K 11/08* (2006.01)  *C04B 35/50* (2006.01)
*C04B 35/653* (2006.01)  *C09K 11/80* (2006.01)
*H01L 33/50* (2010.01)

(86) International application number:
**PCT/JP2015/058010**

(87) International publication number:
**WO 2015/141711 (24.09.2015 Gazette 2015/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **18.03.2014 JP 2014054361**

(71) Applicant: **UBE Industries, Ltd.**
**Ube-shi, Yamaguchi 755-8633 (JP)**

(72) Inventors:
• **ASAI, Shiyohei**
**Ube-shi**
**Yamaguchi 755-8633 (JP)**

• **YAMANAGA, Masataka**
**Ube-shi**
**Yamaguchi 755-8633 (JP)**
• **KUWAHARA, Kazuki**
**Ube-shi**
**Yamaguchi 755-8633 (JP)**
• **NAGAO, Yuki**
**Tokyo 105-8449 (JP)**
• **SHIBATA, Koji**
**Ube-shi**
**Yamaguchi 755-8633 (JP)**
• **KAWANO, Takafumi**
**Ube-shi**
**Yamaguchi 755-8633 (JP)**

(74) Representative: **Michalski Hüttermann & Partner**
**Patentanwälte mbB**
**Speditionstraße 21**
**40221 Düsseldorf (DE)**

(54) **CERAMIC COMPOSITE MATERIAL FOR OPTICAL CONVERSION, PRODUCTION METHOD THEREFOR, AND LIGHT-EMITTING DEVICE PROVIDED WITH SAME**

(57) An objective of the present invention is to provide a ceramic composite material for light conversion which exhibits excellent heat resistance, durability, and the like as a light converting member of an optical device such as a white light emitting diode, easily controls the ratio of light from a light source and fluorescence, can reduce color unevenness and variance of emitted light, and has high internal quantum efficiency and fluorescence intensity, a method for producing the same, and a light emitting device which includes the same and has high light conversion efficiency. Provided is a ceramic composite material for light conversion including: a fluorescence phase; and a light transmitting phase, the fluorescence phase being a phase containing $Ln_3Al_5O_{12}$:Ce (Ln is at least one element selected from Y, Lu, and Tb, and Ce is an activation element), and the light transmitting phase being a phase containing $LaAl_{11}O_{18}$.

EP 3 121 246 A1

**Description**

TECHNICAL FIELD

The present invention relates to a ceramic composite material for light conversion, which is used in a light emitting device such as a light emitting diode that can be utilized in a display, a lighting, a back light source, or the like, a method for producing the same, and a light emitting device including the same.

BACKGROUND ART

Recently, development research has been actively performed on white light emitting devices utilizing a blue light emitting element as a light emitting source. In particular, the white light emitting diodes using a blue light emitting diode element are light in weight, use no mercury, and are long in lifetime, and thus the rapid expansion of the demand can be expected in the future. Incidentally, a light emitting device using a light emitting diode element as a light emitting element is referred to as a "light emitting diode." A method, which is the most commonly adopted, for converting blue light from a blue light emitting diode element into white light is a method in which yellow, which is a complementary color of blue, is mixed with blue light from the blue light emitting diode element to obtain pseudo white. As described in, for example, Patent Literature 1, a coating layer containing a fluorescent substance, which absorbs a part of blue light to emit yellow light, is provided on the whole surface of a diode element, which emits blue light, and a mold layer or the like, which mixes blue light from the light source with the yellow light from the fluorescent substance, is provided ahead, whereby a white light emitting diode can be configured. As the fluorescent substance, YAG ($Y_3Al_5O_{12}$) powder activated by cerium (hereinafter, referred to as "YAG:Ce") or the like is used.

However, in the structure of the white light emitting diode typified by the device disclosed in Patent Literature 1, which are commonly used now, the fluorescent substance powder is mixed with a resin such as epoxy and coated, and thus it is difficult to ensure the homogeneity in the mixed state of the fluorescent substance powder and the resin and to control the stabilization of the thickness of a coating film, and the like, and it is pointed out that color unevenness or variance of the white light emitting diode easily occurs. In addition, a translucent resin to be necessary for applying the fluorescent substance powder and for transmitting the coating film without light conversion of a part of blue light from the light source has an inferior heat resistance, and thus the transmittance is easily reduced due to the deterioration caused by heat from the light emitting element. Accordingly, this is a bottleneck for increasing the output of the white light emitting diode, which is required now.

In this regard, an inorganic light converting material having a fluorescence phase, which is configured without use of a resin, as a light converting member of an optical device, such as a white light emitting diode, has been studied, and an optical device using this material as a light converting member has been studied.

For example, Patent Literature 2 discloses a wavelength conversion member which is produced by mixing an aluminate fluorescent substance powder, which is activated with cerium (Ce), represented by a general formula: $M_3(Al_{1-v}Ga_v)_5O_{12}$:Ce (in the formula, M is at least one kind selected from Lu, Y, Gd, Tb, and v satisfies $0 \leq v \leq 0.8$) and a glass material and melting this glass material so that the fluorescent substance powder is dispersed in the glass material.

Further, Patent Literature 3 discloses a ceramics composite including a fluorescent substance phase formed from YAG containing Ce, which is obtained by sintering, and a matrix phase formed from translucent ceramics such as $Al_2O_3$.

Citation List

Patent Literatures

Patent Literature 1: JP 2000-208815 A
Patent Literature 2: JP 2008-041796 A
Patent Literature 3: JP 2012-062459 A

Summary of Invention

Technical Problem

However, in the wavelength conversion member disclosed in Patent Literature 2, since the matrix thereof is glass, although heat resistance and durability are improved, the wavelength conversion member has problems in that it is difficult to uniformly disperse the fluorescent substance powder in the glass serving as the matrix and color unevenness or variance caused by an emission angle easily occurs in the light to be emitted.

Further, the ceramics composite described in Patent Literature 3 does not have a problem of heat resistance, durability, or the like and a problem in dispersibility of the fluorescent substance powder since the matrix (light transmitting phase) is ceramics and a structure in which the fluorescent substance powder is dispersed in the light transmitting phase is not employed. However, there is a need for further improvement in optical properties.

In this regard, an objective of the present invention is to provide a ceramic composite material for light conversion which exhibits excellent heat resistance, durability, and the like as a light converting member of an optical device such as a white light emitting diode, easily controls the ratio of light from a light source and fluorescence, can reduce color unevenness and variance of emitted light, and has high internal quantum efficiency and fluorescence intensity, a method for producing the same, and a light emitting device which includes the same and has high light conversion efficiency.

Solution to Problem

As a result of intensive studies to solve the above-described problems, the present inventors have found that a ceramic composite material for light conversion, which is configured by a fluorescence phase containing $Ln_3Al_5O_{12}$:Ce (Ln is at least one element selected from Y, Lu, and Tb and Ce is an activation element) and a light transmitting phase containing $LaAl_{11}O_{18}$, has high internal quantum efficiency and fluorescence intensity, and a light emitting device using this ceramic composite material for light conversion has high light conversion efficiency. The present invention has been accomplished based on this finding.

That is, the present invention relates to a ceramic composite material for light conversion including: a fluorescence phase; and a light transmitting phase, the fluorescence phase being a phase containing $Ln_3Al_5O_{12}$:Ce (Ln is at least one element selected from Y, Lu, and Tb, and Ce is an activation element), and the light transmitting phase being a phase containing $LaAl_{11}O_{18}$.

In the present invention, the fluorescence phase is preferably a phase containing $(Ln,La)_3Al_5O_{12}$:Ce (Ln is at least one element selected from Y, Lu, and Tb, and Ce is an activation element).

Further, the light transmitting phase is preferably a phase containing 9 to 100% by mass of $LaAl_1O_{18}$.

Further, the light transmitting phase is preferably a phase further containing at least one kind selected from $\alpha$-$Al_2O_3$ and $LaAlO_3$.

Further, the ceramic composite material for light conversion is preferably subjected to heat treatment at 1000 to 2000°C in an inert gas atmosphere or a reducing gas atmosphere after firing.

Further, the present invention relates to a light emitting device including: a light emitting element; and the above-described ceramic composite material for light conversion.

Further, the present invention relates to a light emitting device including: a light emitting element having a peak at a wavelength of 420 to 500 nm; and the above-described ceramic composite material for light conversion emitting fluorescence which has a dominant wavelength at 540 to 580 nm.

In the present invention, the light emitting element is preferably a light emitting diode element.

Further, the present invention relates to a method for producing a ceramic composite material for light conversion including: a calcining step of calcining a mixed powder containing an Al source compound, a Ln source compound (Ln is at least one element selected from Y, Lu, and Tb), and a Ce source compound; and a firing step of firing a La-containing mixed powder obtained by adding 1 to 50% by mass of La source compound with respect to 100% by mass of the calcined powder obtained in the calcining step, in terms of the oxide.

The present invention preferably further includes a heat treatment step of performing heat treatment at 1000 to 2000°C in an inert gas atmosphere or a reducing gas atmosphere after the firing step.

Further, the La-containing mixed powder is preferably fired after being molded by at least one molding method selected from a press molding method, a sheet molding method, and an extrusion molding method.

Advantageous Effects of Invention

According to the present invention, it is possible to provide a ceramic composite material for light conversion which exhibits excellent heat resistance, durability, and the like as a light converting member of an optical device such as a white light emitting diode, easily controls the ratio of light from a light source and fluorescence, can reduce color unevenness and variance of emitted light, and has high internal quantum efficiency and fluorescence intensity, and a method for producing the same.

In addition, it is possible to provide a light emitting device in which a light transmitting phase of a light converting portion of an optical device such as a light emitting diode can be configured by using an inorganic crystalline substance without use of a resin or the like that is deteriorated by light or heat and which has a long service life and high light conversion efficiency.

BRIEF DESCRIPTION OF DRAWINGS

FIGS. 1A to 1C are diagrams showing SEM photographs of Example 21 (Fig. 1A), Example 18 (Fig. 1B), and Comparative Example 3 (Fig. 1C).

FIGS. 2A and 2B are diagrams showing dark-field STEM photographs in an interface portion between a fluorescence phase particle and a light transmitting phase particle of Example 35 (FIG. 2A) and Comparative Example 3 (FIG. 2B).

DESCRIPTION OF EMBODIMENTS

Hereinafter, the present invention will be described in detail.

(Ceramic Composite Material for Light Conversion)

A ceramic composite material for light conversion of the present invention includes: a fluorescence phase; and a light transmitting phase, the fluorescence phase being a phase containing $Ln_3Al_5O_{12}$:Ce (Ln is at least one element selected from Y, Lu, and Tb, and Ce is an activation element), and the light transmitting phase being a phase containing $LaAl_{11}O_{18}$.

The ceramic composite material for light conversion of the present invention is configured by a fluorescence phase which converts received light into light with a different wavelength and emits the converted light, that is, has fluorescent properties and a light transmitting phase which does not convert received light into light with a different wavelength and allows the received light to pass through the phase without any change. By controlling the ratio of the fluorescence phase and the light transmitting phase, the ratio of light converted by the fluorescence phase and light passing through the light transmitting phase without conversion can be controlled, and chromaticity of light emitted by an optical device, which uses the ceramic composite material for light conversion of the present invention as a light converting portion, can be controlled.

In the ceramic composite material for light conversion of the present invention, the ratio of the fluorescence phase is preferably 10 to 90% by mass. The reason for this is that when the ratio is within this range, the light conversion efficiency of the ceramic composite material for light conversion can be maintained high, and there is no case where the thickness of the ceramic composite material for light conversion is too small and is difficult to handle when the ceramic composite material for light conversion is applied to a light converting portion of the optical device. From the same viewpoint, the ratio of the fluorescence phase is more preferably 20 to 85% by mass, still more preferably 30 to 80% by mass, and particularly preferably 40 to 75% by mass. In addition, the ceramic composite material for light conversion of the present invention is preferably configured only by the fluorescence phase and the light transmitting phase described above.

In the present invention, the fluorescence phase contains $Ln_3Al_5O_{12}$:Ce (Ln is at least one element selected from Y, Lu, and Tb and Ce is an activation element). Ln may be at least one element selected from Y, Lu, and Tb and may be a plurality of these elements. In addition, the $Ln_3Al_5O_{12}$:Ce of the fluorescence phase is preferably $(Ln, La)_3Al_5O_{12}$:Ce (Ln is at least one element selected from Y, Lu, and Tb and Ce is an activation element). Incidentally, in the present invention, the chemical formula represented as $(Ln,La)_3Al_5O_{12}$:Ce means that $(Ln,La)_3Al_5O_{12}$:Ce contains Ln and La. $Ln_3Al_5O_{12}$:Ce can further contain Ga and a rare-earth element, such as Gd, other than Ln and Ce, and for example, in the case of containing Gd, the wavelength of fluorescence emitted from the fluorescence phase can be elongated efficiently.

In the present invention, the light transmitting phase is a phase formed by a crystal which does not convert received light into light with a different wavelength and allows the received light to pass through the crystal with a wavelength without any change, and is a phase which contains $LaAl_{11}O_{18}$ and, as an arbitrary component, at least one kind selected from $\alpha$-$Al_2O_3$ and $LaAlO_3$. Each crystal constituting the light transmitting phase may be one consecutive phase or may be formed by a plurality of crystal grains. For example, in a case where the light transmitting phase according to the present invention is formed from $LaAl_{11}O_{18}$ and $\alpha$-$Al_2O_3$, each crystal may be formed by a plurality of $LaAl_{11}O_{18}$ crystal grains and a plurality of $\alpha$-$Al_2O_3$ crystal grains.

The ratio of $LaAl_{11}O_{18}$ in the light transmitting phase is preferably 9 to 100% by mass. Further, the light transmitting phase may be a phase containing at least one kind selected from $\alpha$-$Al_2O_3$ and $LaAlO_3$, in addition to $LaAl_{11}O_{18}$. The ratio of the $\alpha$-$Al_2O_3$ in the light transmitting phase is preferably 0 to 91% by mass. Further, the ratio of $LaAlO_3$ in the light transmitting phase is preferably 0 to 21% by mass. With the above-described configuration, the ceramic composite material for light conversion of the present invention has high internal quantum efficiency and fluorescence intensity.

Regarding the light transmitting phase, particularly, it is more preferable that the ratio of $LaAl_{11}O_{18}$ in the light transmitting phase be 70 to 100% by mass and the ratio of $\alpha$-$Al_2O_3$ in the light transmitting phase be 0 to 30% by mass, or the ratio of $LaAl_{11}O_{18}$ in the light transmitting phase be 95 to 100% by mass and the ratio of $LaAlO_3$ in the light transmitting phase be 0 to 5% by mass. When the light transmitting phase has the above-described configuration, the ceramic composite material for light conversion of the present invention has particularly high internal quantum efficiency and fluorescence intensity.

As the ratio of $LaAl_{11}O_{18}$ in the light transmitting phase is increased, the internal quantum efficiency and the fluorescence intensity of the ceramic composite material for light conversion of the present invention are increased. Therefore, the light transmitting phase is particularly preferably formed substantially only from $LaA1_{11}O_{18}$. $LaAl_{11}O_{18}$ according to present invention is a hexagonal lanthanum aluminum oxide represented by Chemical Formula: $LaAl_{11}O_{18}$. In addition, examples of an analogous compound include hexagonal lanthanum aluminum oxides represented by $La_2Al_{24\cdot4}O_{39\cdot6}$, $La_{0.9}Al_{11.76}O_{19}$, $La_{1.4}Al_{22.6}O_{36}$, $La_{0.827}Al_{11.9}O_{19\cdot09}$, $La_{0.9}Al_{11.95}O_{18.9}$, $La_{0.85}Al_{11.5}O_{18.5}$, $La_{0.85}Al_{11.55}O_{18.6}$, and $La_{0.85}Al_{11.6}O_{18.675}$, and the same effect may be obtained even in the case of these lanthanum aluminum oxides. Herein, the ceramic composite material for light conversion of the present invention in which the light transmitting phase is formed substantially only from $LaAl_{11}O_{18}$ may contain components other than $LaAl_{11}O_{18}$ to a degree that does not affect the internal quantum efficiency and the fluorescence intensity.

When the ratio of $LaAl_{11}O_{18}$ in the light transmitting phase is high, La is partially contained as a solid solution in the fluorescence phase, and $Ln_3Al_5O_{12}$:Ce of the fluorescence phase becomes $(Ln,La)_3Al_5O_{12}$:Ce (Ln is at least one element selected from Y, Lu, and Tb, and Ce is an activation element) . As described above, when the ratio of $LaAl_{11}O_{18}$ in the light transmitting phase is high, the ceramic composite material for light conversion has high internal quantum efficiency and fluorescence intensity. Therefore, when $Ln_3Al_5O_{12}$:Ce of the fluorescence phase is $(Ln,La)_3Al_5O_{12}$:Ce, the ceramic composite material for light conversion has high internal quantum efficiency and fluorescence intensity.

$LaAl_{11}O_{18}$ according to the present invention may contain Ln and/or Ce. Further, when $Ln_3Al_5O_{12}$:Ce or $(Ln,La)_3Al_5O_{12}$:Ce of the fluorescence phase contains a rare-earth element other than Ln and Ce, $LaAl_{11}O_{18}$ according to the present invention may contain the rare-earth element other than Ln and Ce.

Further, the ceramic composite material for light conversion of the present invention may contain components other than $Ln_3Al_5O_{12}$:Ce, which is contained as a fluorescence phase, $LaAl_{11}O_{18}$, which is contained as a light transmitting phase, and $\alpha$-$Al_2O_3$ and $LaAlO_3$, which are contained as an arbitrary component of the light transmitting phase, to a degree that does not affect fluorescent properties. Examples of these components include composite oxides such as $CeAlO_3$, $CeAl_{11}O_{18}$, and $(Ln,Ce)AlO_3$. Further, when $Ln_3Al_5O_{12}$:Ce contains a rare-earth element such as Gd other than Ln and Ce, for example, when the rare-earth element is Gd, the ceramic composite material for light conversion of the present invention may contain components such as $Gd_4Al_2O_9$, $GdAlO_3$, and $(Ln,Ce,Gd)AlO_3$, in addition to the above-described components.

The particle diameter of each of the fluorescence phase particle and the light transmitting phase particle constituting the ceramic composite material for light conversion of the present invention is preferably 1 $\mu$m or more but 3.5 $\mu$m or less and more preferably 1.5 $\mu$m or more but 3.5 $\mu$m or less. When the particle diameter is less than 1 $\mu$m, the relative fluorescence intensity and the normalized luminous flux are reduced, which is not preferable. In addition, when the particle diameter is more than 3.5 $\mu$m, in order to increase the particle diameter, it is necessary to increase the firing temperature and the firing time, which is not preferable in terms of production. Furthermore, when the firing temperature and the firing time are increased, the concentration of Ce as an activator agent is easily changed, which is not preferable. Regarding the particle diameter of each of the fluorescence phase particle and the light transmitting phase particle, the equivalent circle diameter (Heywood diameter) of the particle can be obtained from a photograph of a scanning electron microscope (SEM) by using an image analysis software as a particle diameter.

In the present invention, as the ratio of the $LaAl_{11}O_{18}$ phase of the light transmitting phase is increased, the concentration of Ce present in the interface between the light transmitting phase and the fluorescence phase is easily decreased, and the internal quantum efficiency and the fluorescence intensity of the ceramic composite material for light conversion of the present invention are increased. Ce present in the interface between the light transmitting phase and the fluorescence phase can be obtained by energy dispersive X-ray spectrometry (EDS) of a scanning transmission electron microscope (STEM). The concentration of Ce at the interface is preferably 3.5 at% or less, more preferably 1.0 at% or less, and still more preferably 0.5 at% or less.

When there is an area in which an element serving as a luminescent center is present in high concentration, it is known that the light conversion efficiency of the luminescent center in this area is deteriorated, and this is generally called concentration quenching. In addition, in an area in which the concentration of Ce is high, it is considered that the refractive index difference between the fluorescence phase and the light transmitting phase is increased, light scattering at the interface easily occurs, and the light conversion efficiency is decreased. In the ceramic composite material for light conversion according to the present invention, when the light transmitting phase contains the $LaAl_{11}O_{18}$ phase, it is speculated that an increase in Ce concentration at the interface between the fluorescence phase and the light transmitting phase is suppressed, and the internal quantum efficiency and the fluorescence intensity are increased as compared with the ceramic composite material for light conversion of the related art.

The ceramic composite material for light conversion according to the present invention can efficiently emit fluorescence having a dominant wavelength at 540 to 580 nm by absorbing light (excitation light) having a peak at a wavelength of 420 to 500 nm, whereby yellow fluorescence can be efficiently obtained. Even when the excitation light has a wavelength of 400 to 419 nm or a wavelength of 501 to 530 nm, the ceramic composite material for light conversion according to the present invention can emit fluorescence although the efficiency is reduced. Further, even when the excitation light is near-ultraviolet light having a wavelength of 300 to 360 nm, the ceramic composite material for light conversion according to the present invention can emit fluorescence.

Further, the ceramic composite material for light conversion of the present invention can be processed in an arbitrary form, but is preferably processed in a plate-shaped body. The plate-shaped body is a shape which can be easily subjected to molding process. This is because an optical device, which converts light from a light source and emits light, can be configured only by adjusting the thickness of the ceramic composite material for light conversion such that emission of desired chromaticity is achieved and mounting the ceramic composite material for light conversion on the optical device.

(Method for Producing Ceramic Composite Material for Light Conversion)

The ceramic composite material for light conversion according to the present invention can be produced by mixing raw material powders at a ratio at which a ceramic composite material for light conversion having a desired component proportion can be obtained and molding and firing the obtained raw material mixed powder.

As a preferred producing method, it is possible to employ a method in which, first, raw material powders other than a La source compound serving as a La source of the ceramic composite material for light conversion are mixed, the obtained mixed powder is calcined to prepare a calcined powder formed from $Ln_3Al_5O_{12}$:Ce and $\alpha$-$Al_2O_3$ in advance, the La source compound is then added to the calcined powder such that the component of the ceramic composite material for light conversion according to the present invention is achieved, the La source compound and the calcined powder are mixed, and then the obtained La-containing mixed powder is molded and fired. According to this method, it is possible to produce the ceramic composite material for light conversion according to the present invention even in a short firing time.

As the raw material powders other than the La source compound, an Al source compound, a Ln source compound (Ln is at least one element selected from Y, Lu, and Tb), and a Ce source compound, which constitute the ceramic composite material for light conversion according to the present invention, are mentioned. The Al source compound, the Ln source compound, and the Ce source compound each are preferably $Al_2O_3$, $Ln_2O_3$ (Ln is at least one element selected from Y, Lu, and Tb), and $CeO_2$, which are oxides of metal elements; however, they may not be an oxide at the time of mixing, or may be a compound which is easily changed to an oxide in the firing process or the like, such as carbonate.

The method of mixing raw material powders other than the La source compound is not particularly limited, and a method known per se, for example, a method of drymixing the substances, or a method of wet mixing the substances in an inert solvent substantially incapable of reacting with each component of the raw material and then removing the solvent, can be employed. As the solvent when the wet mixing method is employed, alcohols such as methanol and ethanol are generally used. As the mixing apparatus, a V-shaped mixer, a rocking mixer, a ball mill, a vibration mill, a medium stirring mill, and the like are suitably used. Incidentally, as a method of mixing raw material powders in a case where all of raw material powders are mixed at the same time, the same methods are suitably used.

The atmosphere at the time of calcining in a case where the calcined powder is prepared in advance is not particularly limited, and is preferably an air atmosphere, an inert atmosphere, or a vacuum atmosphere. The temperature at the time of calcining is temperature at which a powder formed from $Ln_3Al_5O_{12}$:Ce and $\alpha$-$Al_2O_3$ is generated, and is preferably temperature at which sintering does not excessively progress. Specifically, the temperature at the time of calcining is preferably 1350 to 1550°C. A heating furnace used for calcining is not particularly limited as long as heat treatment under the above conditions can be performed. For example, a batch electric furnace of high frequency induction heating system or resistance heating system, a rotary kiln, a fluidized firing furnace, a pusher-type electric furnace, and the like can be used.

In a case where the calcinedpowder is prepared in advance, the calcined powder may be aggregated or sintered, although depending on the particle size distribution or calcining conditions of the raw material powder, and thus pulverization is performed as necessary. The pulverization method is not particularly limited, and a method known per se, for example, a method of dry pulverizing the substances, or a method of wet pulverizing the substances in an inert solvent substantially incapable of reacting with each component of the calcined powder and then removing the solvent, can be employed. As the solvent when the wet pulverizing method is employed, alcohols such as methanol and ethanol are generally used. As the pulverizing apparatus, a roll crusher, a ball mill, a bead mill, a stamp mill, and the like are suitably used.

In a case where the calcinedpowder is prepared in advance, the La source compound of the raw material powder is additionally added to the calcined powder or a powder obtained by pulverizing the calcined powder such that the constituent of the ceramic composite material for light conversion according to the present invention (the constituent of a final product) is achieved, and these powders are mixed to prepare a La-containing mixed powder. The La source compound to be added is not particularly limited as long as it becomes the constituent of the final product, and is usually 1 to 50% by mass and preferably 1 to 30% by mass with respect to 100% by mass of the calcined powder, in terms of the oxide. Herein, the term "in terms of the oxide" means that the La source compound is converted into $La_2O_3$. In addition, as the La source compound, $La_2O_3$ is preferable; however, the La source compound may not be an oxide at the time of mixing, or may be a compound which is easily changed to an oxide in the firing process or the like, such as carbonate. Further, the mixing method in this case is the same as the aforementioned mixing method for the raw material powder.

The molding method of a raw material mixed powder obtained by mixing all of raw material powders or a La-containing mixed powder, which is obtained by additionally adding a La source compound to the calcined powder prepared from a raw material powder other than the La source compound and then mixing them, is not particularly limited, and a press molding method, a sheet molding method, an extrusion molding method, and the like are suitably used. In a case where a ceramic composite material for light conversion of a plate-shaped body is obtained, a doctor blade method that is one of sheet molding methods is preferably employed, and in order to obtain a denser ceramic composite material for light conversion, a molding method such as warm isostatic pressing that is one of press molding methods is preferably employed after the sheet molding.

The firing method of the molded body obtained by molding according to the above-described method is also similarly applied to the case of a molded body formed from any of mixed powders described above, and the firing method is as follows. The atmosphere at the time of firing the molded body is not particularly limited, and is preferably an air atmosphere, an inert atmosphere, or a vacuum atmosphere. The temperature at the time of firing is not particularly limited as long as it is temperature at which a constituent phase of the ceramic composite material for light conversion according to the present invention is formed, and the temperature is preferably 1600 to 1750°C. A heating furnace used for firing is not particularly limited as long as heat treatment under the above conditions can be performed. For example, a batch electric furnace of high frequency induction heating system or resistance heating system, a rotary kiln, a fluidized firing furnace, a pusher-type electric furnace, and the like can be used. Alternatively, a hot press method that performs molding and firing at the same time can also be employed.

The ceramic composite material for light conversion obtained by firing according to the above-described method may be subjected to heat treatment in an inert gas atmosphere or a reducing gas atmosphere. When the ceramic composite material for light conversion obtained by firing according to the above-described method is subjected to heat treatment at a temperature range of 1000 to 2000°C in an inert gas atmosphere or a reducing gas atmosphere, the fluorescence intensity of the ceramic composite material for light conversion can be further improved. The heat treatment temperature is preferably 1100 to 1700°C and more preferably 1400 to 1600°C.

(Light Emitting Device)

The light emitting device according to the present invention includes a light emitting element and the ceramic composite material for light conversion according to the present invention. The light emitting element is preferably a light emitting element which emits light having a peak at a wavelength of 420 to 500 nm. This is because the fluorescence phase of the ceramic composite material for light conversion is excited by this wavelength to obtain fluorescence. The wavelength more preferably has a peak at 440 to 480 nm. This is because an excitation efficiency of the fluorescence phase is high, and thus the fluorescence can be efficiently obtained, which is preferable for improving the efficiency of the light emitting device. Examples of the light emitting element include a light emitting diode element and an element generating laser light; however, a light emitting diode element is preferable since it is small and inexpensive. As the light emitting diode element, a blue light emitting diode element is preferable.

The ceramic composite material for light conversion is preferably a ceramic composite material for light conversion which emits fluorescence having a dominant wavelength at 540 to 580 nm or a ceramic composite material for light conversion which emits fluorescence having a dominant wavelength at a wavelength of 560 to 580 nm in a case where Gd is contained. The light emitting device is preferably a white light emitting device.

The light emitting device according to the present invention irradiates the ceramic composite material for light conversion with light emitted from the light emitting element and uses light passing through the light transmitting phase of the ceramic composite material for light conversion and light wavelength-converted by the fluorescence phase.

Since the light emitting device according to the present invention includes the ceramic composite material for light conversion according to the present invention, when the light emitting device is combined with a blue light emitting element, it is possible to obtain a white light emitting device with high efficiency. Since the light emitting device according to the present invention includes the ceramic composite material for light conversion according to the present invention, the light emitting device can be tuned to a white color with less color unevenness or variance, and the ceramic composite material for light conversion itself is a bulk body and thus the sealing resin is not necessary, as a result, the deterioration due to heat or light does not occur. Therefore, it is possible to increase the output and improve the efficiency.

In addition, since the light emitting device according to present invention uses the ceramic composite material for light conversion according to the present invention, normalized luminous flux (conversion efficiency) is favorable. The normalized luminous flux (conversion efficiency) is considered to be a ratio of light energy passing through or light-converted by the ceramic composite material for light conversion to light energy emitted by the light emitting element. The ceramic composite material for light conversion of the present invention can convert the light energy emitted from the light emitting element into yellow light and reduce loss of blue light passing through the ceramic composite material for light conversion without light conversion, and thus the ceramic composite material for light conversion has high normalized luminous flux (conversion efficiency).

Examples

Hereinafter, the present invention will be described in more detail by referring to specific examples. First, measurement methods used in the present invention will be described.

(Identification and Quantification Methods of Crystal Phase of Ceramic Composite Material for Light Conversion)

Identification and quantification of the crystal phase constituting the ceramic composite material for light conversion were performed by using an X-ray diffraction apparatus (Ultima IV Protectus) manufactured by Rigaku Corporation using CuK$\alpha$ ray and integrated X-ray powder diffraction software PDXL attached to the apparatus. The X-ray diffraction data was obtained from the X-ray diffraction apparatus, the crystal phase was identified by PDXL, and the crystal phase was quantified by the Rietveld method. The mass ratio of each crystal phase was obtained from the results.

When $Ln_3Al_5O_{12}$:Ce is designated as the fluorescence phase and a crystal phase other than $Ln_3Al_5O_{12}$:Ce is designated as the light transmitting phase, the mass ratio of each phase is obtained, and the mass ratio of $LaAl_{11}O_{18}$ of the light transmitting phase and the mass ratio of $\alpha$-$Al_2O_3$ and $LaAlO_3$ as arbitrary components are divided by the mass ratio of the light transmitting phase. Thus, the mass ratio of each crystal phase constituting the light transmitting phase to the light transmitting phase can be obtained.

Further, the fact that $Ln_3Al_5O_{12}$:Ce or $(Ln, La)_3Al_5O_{12}$:Ce contains Ln, La, and Ce was checked as follows. A reflected electron image of a cross section of the ceramic composite material for light conversion of the present invention which is polished until a mirror surface is obtained was photographed through a scanning electron microscope, and an element mapping diagram of constituent elements in the same field of view as the reflected electron image was obtained through an EDS (Energy Dispersive Spectroscopy) apparatus attached to the microscope. The obtained reflected electron image and the element mapping diagram were compared to each other to check that $Ln_3Al_5O_{12}$:Ce or $(Ln,La)_3Al_5O_{12}$:Ce contains Ce, La, or another rare-earth element.

(Evaluation Method for Fluorescent Properties of Ceramic Composite Material for Light Conversion)

The fluorescence dominant wavelength, the internal quantum efficiency, and the maximum fluorescence intensity of the ceramic composite material for light conversion can be measured and calculated by a solid quantum efficiency measuring apparatus in which an integrating sphere is combined with QE-1100 manufactured by Otsuka Electronics Co., Ltd. A part of the ceramic composite material for light conversion was processed in a circular plate form having a size of $\phi$ 16 x 0.2 mm and set to the inside of the integrating sphere. The excitation light spectrum and the fluorescence spectrum at an excitation wavelength of 460 nm were measured by using a solid quantum efficiency measuring apparatus, and at the same time, the internal quantum efficiency was measured. The internal quantum efficiency was calculated by the following formula (1).

$$\text{Internal quantum efficiency (\%)} = \text{(Fluorescence light quantum/Absorption light quantum)} \times 100 \qquad (1)$$

Further, the excitation light spectrum intensity, the spectrum intensity at 460 nm of the fluorescence spectrum, and the spectrum intensity at a fluorescence peak wavelength of the fluorescence spectrum were derived, and then the maximum fluorescence intensity was calculated by the following formula (2).

$$\text{Maximum fluorescence intensity} = \{\text{Spectrum intensity}$$

$$\text{at fluorescence peak wavelength of fluorescence}$$

$$\text{spectrum/(Excitation light spectrum intensity} - \text{Spectrum}$$

$$\text{intensity at 460 nm of fluorescence spectrum)}\} \quad (2)$$

In the present invention, the relative value of the maximum fluorescence intensity of the ceramic composite material for light conversion related to each Example when the maximum fluorescence intensity of the ceramic composite material for light conversion related to Comparative Example in which the light transmitting phase is configured only by $\alpha$-Al$_2$O$_3$ was taken as 100% was calculated as the relative fluorescence intensity of the ceramic composite material for light conversion related to each Example. As for Example in which Ln is Y, the relative value when the maximum fluorescence intensity of the ceramic composite material for light conversion related to Comparative Example 1 was taken as 100% was defined as the relative fluorescence intensity, and as for Example in which Ln is Lu, the relative value when the maximum fluorescence intensity of the ceramic composite material for light conversion related to Comparative Example 2 was taken as 100% was defined as the relative fluorescence intensity.

(Normalized Luminous Flux of White Light Emitting Diode)

The wavelength conversion member was joined onto a semiconductor light emitting element having an emission color with a peak wavelength of 455 nm by using a silicone resin and measured by a total luminous flux measurement system manufactured by Spectra Co-op. Regarding the normalized luminous flux (conversion efficiency), the normalized luminous flux calculated according to the following formula (3) was defined as the conversion efficiency.

$$\text{Conversion efficiency (normalized luminous flux)} =$$

$$\text{Total luminous flux (lm) when wavelength conversion member}$$

$$\text{is mounted/Total radiant flux (mW) when wavelength conversion}$$

$$\text{member is not mounted} \quad (3)$$

(Example 1)

65.40 g of $\alpha$-Al$_2$O$_3$ powder (purity 99.99%), 34.08 g of Y$_2$O$_3$ powder (purity 99.9%), and 0.52 g of CeO$_2$ powder (purity 99.9%) were weighed respectively, these raw material powders were subjected to wet mixing in ethanol for 24 hours by a ball mill, and then the ethanol as a solvent was removed therefrom using an evaporator to obtain a mixed powder to be used in calcination. The obtained mixed powder to be used in calcination was put into an Al$_2$O$_3$ crucible, was charged in a batch electric furnace, and calcined while being held at 1500°C for 3 hours in an air atmosphere, thereby obtaining a calcined powder formed from Y$_3$Al$_5$O$_{12}$:Ce and Al$_2$O$_3$. The fact that the calcined powder was formed from Y$_3$Al$_5$O$_{12}$:Ce and Al$_2$O$_3$ was checked by X-ray diffraction analysis.

Next, 1% by mass of La$_2$O$_3$ powder (purity 99.9%) with respect to 100% by mass of the calcined powder was added to the obtained calcined powder, these powders were subjected to wet mixing in ethanol for 90 hours by a ball mill, and then the ethanol as a solvent was removed therefrom using an evaporator to prepare a La-containing mixed powder. 15.75 parts by mass of binder resin such as polyvinyl butyral, 2.25 parts by mass of plasticizer such as dibutyl phthalate, 4 parts by mass of dispersant, and 135 parts by mass of organic solvent such as toluene were added with respect to 100 parts by mass of the obtained La-containing mixed powder to prepare a mixed slurry. The mixed slurry was accommodated in a slurry accommodating tank of a doctor blade, and then the mixed slurry was discharged in a sheet form from the downside of the slurry accommodating tank by controlling a variable blade which can control the height of a gap at the downside of the slurry accommodating tank. The discharged mixed slurry was applied onto a PET film, which is fixed to a conveyance table by a vacuum suction pad, to have a thickness of about 50 $\mu$m, and then dried to prepare a green sheet. Six sheets of the obtained green sheet were laminated to have a thickness of 220 to 230 $\mu$m after firing, and pressed by warm isostatic pressing at 85°C and a pressure of 20 MPa to prepare a laminated body. The laminated body was fixed onto a foaming release sheet, which can be peeled off from the laminated body by heating, and cut to have a certain shape. The cut laminated body was heated by a heating machine and separated from the foaming release sheet. The obtained laminated body was held at 1700°C for 6 hours in an air atmosphere by using a batch electric furnace and then fired. In this way, a ceramic composite material for light conversion related to Example 1 was obtained.

Identification and quantification of the crystal phase constituting the obtained ceramic composite material for light conversion were performed by the method described above in (Identification and Quantification Methods of Crystal Phase of Ceramic Composite Material for Light Conversion), and the mass ratio of each crystal phase in the light transmitting phase was calculated. In addition, the fluorescent properties of the ceramic composite material for light conversion related to Example 1 were measured by the method described above in (Evaluation Method of Fluorescent Properties of Ceramic Composite Material for Light Conversion). The fluorescent properties were evaluated while the wavelength of the excitation light was set to 460 nm. The dominant wavelength, the internal quantum efficiency, and the maximum fluorescence intensity were calculated from the obtained emission spectrum. The relative value of the maximum fluorescence intensity of the ceramic composite material for light conversion related to Example 1 when the maximum fluorescence intensity of a ceramic composite material for light conversion related to Comparative Example 1 to be described later was taken as 100% was calculated as the relative fluorescence intensity.

Further, a white light emitting diode was prepared by using the ceramic composite material for light conversion related to Example 1 as a light converting member, and the normalized luminous flux ($\phi v/B\phi e$) was measured by the method described above in (Normalized Luminous Flux of White Light Emitting Diode).

The crystal phase constituting the ceramic composite material for light conversion related to Example 1 and the ratio thereof, the fluorescence dominant wavelength, the internal quantum efficiency, and the relative fluorescence intensity of the ceramic composite material for light conversion when the ceramic composite material for light conversion was excited by light having a wavelength of 460 nm, and the normalized luminous flux ($\phi v/B\phi e$) of the white light emitting diode using the ceramic composite material for light conversion related to Example 1 as a light converting member were presented in Table 1. The ceramic composite material for light conversion related to Example 1 was constituted by $Y_3Al_5O_{12}$:Ce. $LaAl_{11}O_{18}$, and $\alpha$-$Al_2O_3$, the ratio of the $LaAl_{11}O_{18}$ phase in the light transmitting phase was 9.0% by mass, and the ratio of the $\alpha$-$Al_2O_3$ phase in the light transmitting phase was 91.0% by mass. A crystal phase other than these phases was not determined. In addition, the dominant wavelength of the ceramic composite material for light conversion related to Example 1 when the ceramic composite material for light conversion was excited by light having a wavelength of 460 nm was 563 nm, the internal quantum efficiency thereof was 71.6%, and the relative fluorescence intensity thereof was 102%. Thus, all of values of fluorescent properties were higher than those of the following Comparative Example 1 and Comparative Examples 3 to 6 not containing $LaAl_{11}O_{18}$. Further, the normalized luminous flux ($\phi v/B\phi e$) of the white light emitting diode employing the ceramic composite material for light conversion related to Example 1 as a light converting member was 0.250 and was higher than those of Comparative Example 1 and Comparative Examples 3 to 6.

(Examples 2 to 7)

Each ceramic composite material for light conversion related to Examples 2 to 7 was obtained by the same method as in Example 1, except that the mass ratio of the $La_2O_3$ powder to be added to the calcined powder obtained by the same method as in Example 1 with respect to 100% by mass of the calcined powder was changed to be in a range of 2 to 10% by mass. Identification and quantification of the crystal phase constituting the obtained ceramic composite material for light conversion were performed by the same method as in Example 1, and then the mass ratio of each crystal phase in the light transmitting phase was calculated. In addition, the fluorescence dominant wavelength, the internal quantum efficiency, and the maximum fluorescence intensity when the obtained ceramic composite material for light conversion was excited by light having a wavelength of 460 nm were measured by the same method as in Example 1. The relative value of the maximum fluorescence intensity of the ceramic composite material for light conversion related to each of Examples 2 to 7 when the maximum fluorescence intensity of the ceramic composite material for light conversion related to Comparative Example 1 to be described later was taken as 100% was calculated as the relative fluorescence intensity.

Further, a white light emitting diode was prepared in the same manner as in Example 1 by using the ceramic composite material for light conversion related to each of Examples 2 to 7 as a light converting member, and the normalized luminous flux ($\phi v/B\phi e$) thereof was measured.

The crystal phase constituting the ceramic composite material for light conversion related to each of Examples 2 to 7 and the ratio thereof, the fluorescence dominant wavelength, the internal quantum efficiency, and the relative fluorescence intensity of the ceramic composite material for light conversion when the ceramic composite material for light conversion was excited by light having a wavelength of 460 nm, and the normalized luminous flux ($\phi v/B\phi e$) of the white light emitting diode using the ceramic composite material for light conversion related to each of Examples 2 to 7 as a light converting member were presented in Table 1. The ratio of $\alpha$-$Al_2O_3$ contained in the light transmitting phase of the ceramic composite material for light conversion was decreased and the ratio of $LaAl_{11}O_{18}$ was increased in the range until the mass ratio of the $La_2O_3$ powder to be additionally added to the calcined powder to 100% by mass of the calcined powder was 10% by mass, as the ratio of the $La_2O_3$ powder to be added to the calcined powder was increased. According to this, the internal quantum efficiency, the relative fluorescence intensity, and the normalized luminous flux ($\phi$v/B$\phi$e) of the white light emitting diode using the ceramic composite material for light conversion related to each of Examples 2 to 7 as a light converting member were increased. The ceramic composite material for light conversion related to Example 7, which was obtained by additionally adding 10% by mass of $La_2O_3$ powder with respect to 100% by mass of the calcined powder to the calcined powder then firing the mixture, exhibited the highest internal quantum efficiency and relative fluorescence intensity among ceramic composite materials for light conversion according to the present invention in which the content ratio of $LaAl_{11}O_{18}$ in the light transmitting phase was 100% by mass and which contained $Y_3Al_5O_{12}$:Ce (there may be the case of $(Y,La)_3Al_5O_{12}$:Ce in Example in which the amount of addition of La was large) as a fluorescence phase. The dominant wavelength of the ceramic composite material for light conversion related to Example 7 when the ceramic composite material for light conversion was excited by light having a wavelength of 460 nm was 561 nm, the internal quantum efficiency thereof was 89.6%, and the relative fluorescence intensity thereof was 130%. In addition, the normalized luminous flux ($\phi$v/B$\phi$e) of the white light emitting diode employing the ceramic composite material for light conversion related to each of Examples 6 and 7 as a light converting member was highest and 0.292. Incidentally, even in any of Examples 2 to 7, a crystal phase other than the crystal phases presented in Table 1 was not determined.

(Examples 8 to 13)

Each ceramic composite material for light conversion related to Examples 8 to 13 was obtained by the same method as in Example 1, except that the mass ratio of the $La_2O_3$ powder to be added to the calcined powder obtained by the same method as in Example 1 with respect to 100% by mass of the calcined powder was changed to be in a range of 12.5 to 30% by mass. Identification and quantification of the crystal phase constituting the obtained ceramic composite material for light conversion were performed by the same method as in Example 1, and then the mass ratio of each crystal phase in the light transmitting phase was calculated. In addition, the fluorescence dominant wavelength, the internal quantum efficiency, and the maximum fluorescence intensity of the obtained ceramic composite material for light conversion when the ceramic composite material for light conversion was excited by light having a wavelength of 460 nm were measured by the same method as in Example 1. The relative value of the maximum fluorescence intensity of the ceramic composite material for light conversion related to each of Examples 8 to 13 when the maximum fluorescence intensity of the ceramic composite material for light conversion related to Comparative Example 1 to be described later was taken as 100% was calculated as the relative fluorescence intensity.

Further, a white light emitting diode was prepared in the same manner as in Example 1 by using the ceramic composite material for light conversion related to each of Examples 8 to 13 as a light converting member, and the normalized luminous flux ($\phi$v/B$\phi$e) thereof was measured.

The crystal phase constituting the ceramic composite material for light conversion related to each of Examples 8 to 13 and the ratio thereof, the fluorescence dominant wavelength, the internal quantum efficiency, and the relative fluorescence intensity of the ceramic composite material for light conversion when the ceramic composite material for light conversion was excited by light having a wavelength of 460 nm, and the normalized luminous flux ($\phi$v/B$\phi$e) of the white light emitting diode using the ceramic composite material for light conversion related to each of Examples 8 to 13 as a light converting member were presented in Table 1. $LaAlO_3$ was generated in Example 8 in which the mass ratio of the $La_2O_3$ powder to be additionally added to the calcined powder with respect to 100% by mass of the calcined powder was increased to 12.5% by mass. According to this, the ratio of $LaAlO_3$ contained in the light transmitting phase was increased and the ratio of the $LaAl_{11}O_{18}$ phase was decreased in the range in which the mass ratio of the $La_2O_3$ powder to be additionally added to the calcined powder was increased to 30% by mass, as the mass ratio of the $La_2O_3$ powder was increased. As the ratio of $LaAlO_3$ was increased, the internal quantum efficiency, the relative fluorescence intensity, and the normalized luminous flux ($\phi$v/B$\phi$e) of the white light emitting diode were decreased; however, even in the ceramic composite material for light conversion related to Example 13 having the highest ratio of $LaAlO_3$ in the light transmitting phase, the dominant wavelength was 562 nm, the internal quantum efficiency thereof was 65.9%, and the relative fluorescence intensity thereof was 107%, that is, the values of the dominant wavelength, the internal quantum efficiency, and the relative fluorescence intensity were higher than those of the following Comparative Example 1 not containing $LaAl_{11}O_{18}$. In addition, the normalized luminous flux ($\phi$v/B$\phi$e) of the white light emitting diode employing the ceramic composite material for light conversion related to Example 13 as a light converting member was 0.253 and was higher than that of the following Comparative Example 1. Incidentally, even in any of Examples 8 to 13, a crystal phase other than the crystal phases presented in Table 1 was not determined.

(Comparative Example 1)

A ceramic composite material for light conversion related to Comparative Example 1 was obtained by the same method as in Example 1, except that the $La_2O_3$ powder was not additionally added to the calcined powder obtained by the same method as in Example 1 and only the calcined powder was molded. Identification and quantification of the crystal phase constituting the obtained ceramic composite material for light conversion were performed by the same method as in Example 1, and then the mass ratio of each crystal phase in the light transmitting phase was calculated. In addition, the fluorescence dominant wavelength, the internal quantum efficiency, and the maximum fluorescence intensity of the obtained ceramic composite material for light conversion when the obtained ceramic composite material for light conversion was excited by light having a wavelength of 460 nmwere measured by the same method as in Example 1.

Further, a white light emitting diode was prepared in the same manner as in Example 1 by using the ceramic composite material for light conversion related to Comparative Example 1 as a light converting member, and the normalized luminous flux ($\phi v/B\phi e$) thereof was measured.

The crystal phase constituting the ceramic composite material for light conversion related to Comparative Example 1 and the ratio thereof, the fluorescence dominant wavelength, the internal quantum efficiency, and the relative fluorescence intensity of the ceramic composite material for light conversion when the ceramic composite material for light conversion was excited by light having a wavelength of 460 nm, and the normalized luminous flux ($\phi v/B\phi e$) of the white light emitting diode using the ceramic composite material for light conversion related to Comparative Example 1 as a light converting member were presented in Table 1. The ceramic composite material for light conversion related to Comparative Example 1 was configured only by $Y_3Al_5O_{12}$:Ce and $\alpha$-$Al_2O_3$, and the light transmitting phase was configured only by $\alpha$-$Al_2O_3$. In addition, the dominant wavelength of the ceramic composite material for light conversion related to Comparative Example 1 when the ceramic composite material for light conversion was excited by light having a wavelength of 460 nm was 563 nm, and the internal quantum efficiency thereof was 64.1%. The relative value of the maximum fluorescence intensity of the ceramic composite material for light conversion related to each of Examples 1 to 13 when the maximum fluorescence intensity of the ceramic composite material for light conversion related to Comparative Example 1 was taken as 100% was defined as the relative fluorescence intensity. Further, the normalized luminous flux ($\phi v/B\phi e$) of the white light emitting diode employing the ceramic composite material for light conversion related to Comparative Example 1 as a light converting member was 0.234.

(Example 14)

A calcined powder formed from $Lu_3Al_5O_{12}$:Ce and $Al_2O_3$ was obtained by the same method as in Example 1, except that 53.89 g of $\alpha$-$Al_2O_3$ powder (purity 99.99%), 45.71 g of $Lu_2O_3$ powder (purity 99.9%), and 0.40 g of $CeO_2$ powder (purity 99.9%) were weighed respectively, and were used as a raw material. The fact that the calcined powder was formed from $Lu_3Al_5O_{12}$:Ce and $Al_2O_3$ was checked by X-ray diffraction analysis, similarly to Example 1. 1% by mass of $La_2O_3$ powder (purity 99.9%) with respect to 100% by mass of the calcined powder was added to the obtained calcined powder, mixed, molded, and fired in the same manner as in Example 1 to obtain a ceramic composite material for light conversion related to Example 14. Identification and quantification of the crystal phase constituting the obtained ceramic composite material for light conversion were performed by the same method as in Example 1, and then the mass ratio of each crystal phase in the light transmitting phase was calculated. In addition, the fluorescence dominant wavelength, the internal quantum efficiency, and the maximum fluorescence intensity of the obtained ceramic composite material for light conversion when the ceramic composite material for light conversion was excited by light having a wavelength of 460 nm were measured by the same method as in Example 1. The relative value of the maximum fluorescence intensity of the ceramic composite material for light conversion related to Example 14 when the maximumfluorescenceintensity of a ceramic composite material for light conversion related to Comparative Example 2 to be described later was taken as 100% was calculated as the relative fluorescence intensity.

Further, a white light emitting diode was prepared in the same manner as in Example 1 by using the ceramic composite material for light conversion related to Example 14 as a light converting member, and the normalized luminous flux ($\phi v/B\phi e$) thereof was measured.

The crystal phase constituting the ceramic composite material for light conversion related to Example 14 and the ratio thereof, the fluorescence dominant wavelength, the internal quantum efficiency, and the relative fluorescence intensity of the ceramic composite material for light conversion when the ceramic composite material for light conversion was excited by light having a wavelength of 460 nm, and the normalized luminous flux ($\phi v/B\phi e$) of the white light emitting diode using the ceramic composite material for light conversion related to Example 14 as a light converting member were presented in Table 2. The ceramic composite material for light conversion related to Example 14 was configured by $L_{U3}Al_5O_{12}$:Ce, $LaAl_{11}O_{18}$, and $\alpha$-$Al_2O_3$, the ratio of the $LaAl_{11}O_{18}$ phase in the light transmitting phase was 15.0% by mass, and the ratio of the $\alpha$-$Al_2O_3$ phase in the light transmitting phase was 85.0% by mass. A crystal phase other than these phases was not determined. In addition, the dominant wavelength of the ceramic composite material for light conversion related to Example 14 when the ceramic composite material for light conversion was excited by light having a wavelength of 460 nm was 547 nm, the internal quantum efficiency thereof was 79.3%, and the relative fluorescence intensity thereof was 109%. Thus, all of values were higher than those of the following Comparative Example 2 not containing $LaAl_{11}O_{18}$. Further, the normalized luminous flux ($\phi v/B\phi e$) of the white light emitting diode employing the ceramic composite material for light conversion related to Example 14 as a light converting member was 0.254 and was higher than that of Comparative Example 2.

(Examples 15 to 21)

Each ceramic composite material for light conversion related to Examples 15 to 21 was obtained by the same method as in Example 14, except that the mass ratio of the $La_2O_3$ powder to be added to the calcined powder obtained by the same method as in Example 14 with respect to 100% by mass of the calcined powder was changed to be in a range of 2 to 12.5% by mass. Identification and quantification of the crystal phase constituting the obtained ceramic composite material for light conversion were performed by the same method as in Example 1, and the mass ratio of each crystal phase in the light transmitting phase was calculated. In addition, the fluorescence dominant wavelength, the internal quantum efficiency, and the maximum fluorescence intensity of the obtained ceramic composite material for light conversion when the ceramic composite material for light conversion was excited by light having a wavelength of 460 nm were measured by the same method as in Example 1. The relative value of the maximum fluorescence intensity of the ceramic composite material for light conversion related to each of Examples 15 to 21 when the maximum fluorescence intensity of the ceramic composite material for light conversion related to Comparative Example 2 to be described later was taken as 100% was calculated as the relative fluorescence intensity.

Further, a white light emitting diode was prepared in the same manner as in Example 1 by using the ceramic composite material for light conversion related to each of Examples 15 to 21 as a light converting member, and the normalized luminous flux ($\phi v/B\phi e$) thereof was measured.

The crystal phase constituting the ceramic composite material for light conversion related to each of Examples 15 to 21 and the ratio thereof, the fluorescence dominant wavelength, the internal quantum efficiency, and the relative fluorescence intensity of the ceramic composite material for light conversion when the ceramic composite material for light conversion was excited by light having a wavelength of 460 nm, and the normalized luminous flux ($\phi v/B\phi e$) of the white light emitting diode using the ceramic composite material for light conversion related to each of Examples 15 to 21 as a light converting member were presented in Table 2. The ratio of $\alpha$-$Al_2O_3$ contained in the light transmitting phase of the ceramic composite material for light conversion was decreased and the ratio of $LaAl_{11}O_{18}$ was increased in the range until the mass ratio of the $La_2O_3$ powder to be additionally added to the calcined powder to 100% by mass of the calcined powder was 12.5% by mass, as the ratio of the $La_2O_3$ powder to be added to the calcined powder was increased. According to this, the internal quantum efficiency, the relative fluorescence intensity, and the normalized luminous flux ($\phi v/B\phi e$) of the white light emitting diode were increased. In the ceramic composite material for light conversion related to Example 21, which was obtained by additionally adding 12.5% by mass of $La_2O_3$ powder with respect to 100% by mass of the calcined powder to the calcined powder then firing the mixture, the content ratio of $LaAl_{11}O_{18}$ in the light transmitting phase was 100% by mass, and the relevant ceramic composite material for light conversion exhibited the highest internal quantum efficiency and relative fluorescence intensity among ceramic composite materials for light conversion according to the present invention which contained $Lu_3Al_5O_{12}$:Ce (there may be the case of $(Lu,La)_3Al_5O_{12}$:Ce in Example in which the amount of addition of La was large) as a fluorescence phase. The dominant wavelength of the ceramic composite material for light conversion related to Example 21 when the ceramic composite material for light conversion was excited by light having a wavelength of 460 nm was 544 nm, the internal quantum efficiency thereof was 90.0%, and the relative fluorescence intensity thereof was 131%. In addition, the normalized luminous flux ($\phi v/B\phi e$) of the white light emitting diode employing the ceramic composite material for light conversion related to Example 21 as a light converting member was highest and 0.294. Incidentally, even in any of Examples 15 to 21, a crystal phase other than the crystal phases presented in Table 2 was not determined.

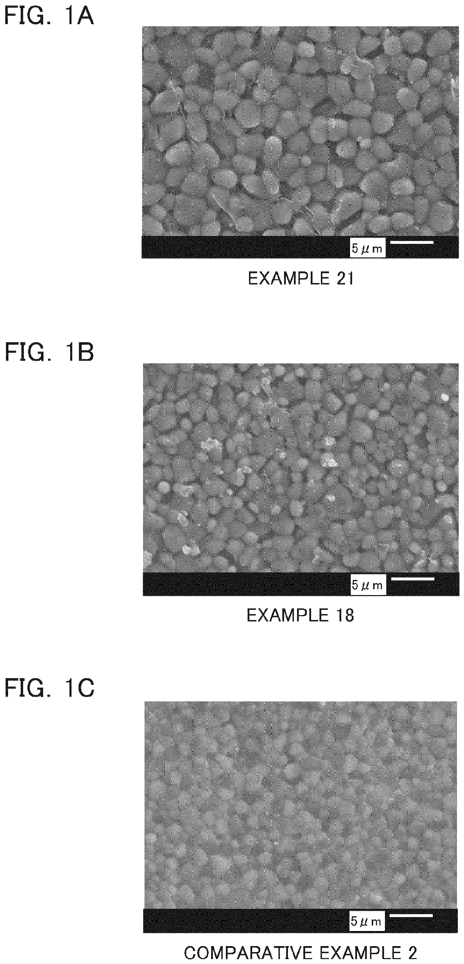

FIGS. 1A to 1C show SEM photographs obtained by photographing the surface of the ceramic composite material for light conversion of each of Examples 18 and 21 and Comparative Example 2 to be described later through a scanning electron microscope (JSM-6510 Type manufactured by JEOL Ltd.). The equivalent circle diameter was obtained using SEM photographs of FIGS. 1A to 1C by an image analysis software (Mac-View Ver. 4 produced by Mountech Co., Ltd.). The results thereof are presented in Table 4. It is found that the particle diameters of Examples 18 and 21 each are 1.40 $\mu$m and 3.0 $\mu$m and are larger than the particle diameter of Comparative Example 2 (0.83 $\mu$m).

(Examples 22 to 26)

Each ceramic composite material for light conversion related to Examples 22 to 26 was obtained by the same method as in Example 14, except that the mass ratio of the $La_2O_3$ powder to be added to the calcined powder obtained by the same method as in Example 14 with respect to 100% by mass of the calcined powder was changed to be in a range of 15 to 30% by mass. The crystal phase constituting the obtained ceramic composite material for light conversion and the ratio thereof, and the fluorescence dominant wavelength, the internal quantum efficiency, and the relative fluorescence intensity of the ceramic composite material for light conversion when the ceramic composite material for light conversion was excited by light having a wavelength of 460 nm were determined by the same method as in Example 1. The relative value of the maximum fluorescence intensity of the ceramic composite material for light conversion related to each of Examples 22 to 26 when the maximum fluorescence intensity of the ceramic composite material for light conversion related to Comparative Example 2 to be described later was taken as 100% was calculated as the relative fluorescence intensity.

Further, a white light emitting diode was prepared in the same manner as in Example 1 by using the ceramic composite material for light conversion related to each of Examples 22 to 26 as a light converting member, and the normalized luminous flux ($\phi$v/B$\phi$e) thereof was measured.

The crystal phase constituting the ceramic composite material for light conversion related to each of Examples 22 to 26 and the ratio thereof, the fluorescence dominant wavelength, the internal quantum efficiency, and the relative fluorescence intensity of the ceramic composite material for light conversion when the ceramic composite material for light conversion was excited by light having a wavelength of 460 nm, and the normalized luminous flux ($\phi$v/B$\phi$e) of the white light emitting diode using the ceramic composite material for light conversion related to each of Examples 22 to 26 as a light converting member were presented in Table 2. $LaAlO_3$ was generated in Example 22 in which the mass ratio of the $La_2O_3$ powder to be additionally added to the calcined powder with respect to 100% by mass of the calcined powder was increased to 15% by mass. According to this, the ratio of $LaAlO_3$ contained in the light transmitting phase was increased and the ratio of the $LaAl_{11}O_{18}$ phase was decreased in the range in which the mass ratio of the $La_2O_3$ powder to be added to the calcined powder was increased to 30% by mass, as the mass ratio of the $La_2O_3$ powder was increased. As the ratio of $LaAlO_3$ was increased, the internal quantum efficiency, the relative fluorescence intensity, and the normalized luminous flux ($\phi$v/B$\phi$e) of the white light emitting diode were decreased; however, even in the ceramic composite material for light conversion related to Example 26 having the highest ratio of $LaAlO_3$ in the light transmitting phase, the dominant wavelength was 545 nm, the internal quantum efficiency thereof was 72.2%, and the relative fluorescence intensity thereof was 108%, that is, the values of the dominant wavelength, the internal quantum efficiency, and the relative fluorescence intensity were higher than those of the following Comparative Example 2 not containing $LaAl_{11}O_{18}$. In addition, the normalized luminous flux ($\phi$v/B$\phi$e) of the white light emitting diode employing the ceramic composite material for light conversion related to Example 26 as a light converting member was 0.243 and was higher than that of the following Comparative Example 2. Incidentally, even in any of Examples 22 to 26, a crystal phase other than the crystal phases presented in Table 1 was not determined.

(Comparative Example 2)

A ceramic composite material for light conversion related to Comparative Example 2 was obtained by the same method as in Example 14, except that the $La_2O_3$ powder was not additionally added to the calcined powder obtained by the same method as in Example 14 and only the calcined powder was molded. Identification and quantification of the crystal phase constituting the obtained ceramic composite material for light conversion were performed by the same method as in Example 1, and then the mass ratio of each crystal phase in the light transmitting phase was calculated. In addition, the fluorescence dominant wavelength, the internal quantum efficiency, and the maximum fluorescence intensity of the obtained ceramic composite material for light conversion when the ceramic composite material for light conversion was excited by light having a wavelength of 460 nm were measured by the same method as in Example 1.

Further, a white light emitting diode was prepared in the same manner as in Example 1 by using the ceramic composite material for light conversion related to Comparative Example 2 as a light converting member, and the normalized luminous flux ($\phi$v/B$\phi$e) thereof was measured.

The crystal phase constituting the ceramic composite material for light conversion related to Comparative Example 2 and the ratio thereof, the fluorescence dominant wavelength, the internal quantum efficiency, and the relative fluorescence intensity of the ceramic composite material for light conversion when the ceramic composite material for light conversion was excited by light having a wavelength of 460 nm, and the normalized luminous flux ($\phi$v/B$\phi$e) of the white light emitting diode using the ceramic composite material for light conversion related to Comparative Example 2 as a light converting member were presented in Table 2. The ceramic composite material for light conversion related to Comparative Example 2 was configured only by $Lu_3Al_5O_{12}$:Ce and $\alpha$-$Al_2O_3$, and the light transmitting phase was configured only by $\alpha$-$Al_2O_3$. In addition, the dominant wavelength of the ceramic composite material for light conversion related to Comparative Example 2 when the ceramic composite material for light conversion was excited by light having a wavelength of 460 nm was 548 nm, and the internal quantum efficiency thereof was 70.8%. The relative value of the maximum fluorescence intensity of the ceramic composite material for light conversion related to each of Examples 14 to 26 when the maximum fluorescence intensity of the ceramic composite material for light conversion related to Comparative Example 2 was taken as 100% was defined as the relative fluorescence intensity. Further, the normalized luminous flux ($\phi$v/B$\phi$e) of the white light emitting diode employing the ceramic composite material for light conversion related to Comparative Example 2 as a light converting member was 0.225.

(Comparative Examples 3 to 6)

Each ceramic composite material for light conversion related to Comparative Examples 3 to 6 was obtained by the same method as in Example 1, except that the powder to be added to the calcined powder obtained by the same method as in Example 1 was changed from the $La_2O_3$ powder to an M-containing compound powder presented in Table 3 and the ratio thereof was changed as presented in Table 3. Identification and quantification of the crystal phase constituting the obtained ceramic composite material for light conversion were performed by the same method as in Example 1, and then the mass ratio of each crystal phase in the light transmitting phase was calculated. In addition, the fluorescence dominant wavelength, the internal quantum efficiency, and the maximum fluorescence intensity of the obtained ceramic composite material for light conversion when the ceramic composite material for light conversion was excited by light having a wavelength of 460 nm were measured by the same method as in Example 1.

Further, a white light emitting diode was prepared in the same manner as in Example 1 by using the ceramic composite material for light conversion related to each of Comparative Examples 3 to 6 as a light converting member, and the normalized luminous flux ($\phi$v/B$\phi$e) thereof was measured.

The crystal phase constituting the ceramic composite material for light conversion related to each of Comparative Examples 3 to 6 and the ratio thereof, the fluorescence dominant wavelength, the internal quantum efficiency, and the relative fluorescence intensity of the ceramic composite material for light conversion when the ceramic composite material for light conversion was excited by light having a wavelength of 460 nm, and the normalized luminous flux ($\phi$v/B$\phi$e) of the white light emitting diode using the ceramic composite material for light conversion related to each of Comparative Examples 3 to 6 as a light converting member were presented in Table 3. The ceramic composite material for light conversion related to each of Comparative Examples 3 to 6 was configured only by $Y_3Al_5O_{12}$:Ce, MxAlyOz ($CeAl_{11}O_{18}$, $CaAl_{12}O_{19}$, $SrAl_{12}O_{19}$, and $BaAl_{12}O_{19}$ in the order from Comparative Example 3), and $\alpha$-$Al_2O_3$, and the light transmitting phase was configured only by MxAlyOz and $\alpha$-$Al_2O_3$. The ceramic composite material for light conversion related to Comparative Examples 3, 5, and 6 when the ceramic composite material for light conversion was excited by light having a wavelength of 460 nm exhibited relatively high maximum fluorescence intensity; however, the internal quantum efficiency of all of Comparative Examples 3, 5, and 6 was low, and the normalized luminous flux ($\phi$v/B$\phi$e) of each of the white light emitting diodes employing these ceramic composite materials for light conversion as a light converting member was a value relatively lower than those of Examples 1 to 13. Further, both the internal quantum efficiency and the maximum fluorescence intensity of the ceramic composite material for light related to Comparative Example 4 were low, and the normalized luminous flux ($\phi$v/B$\phi$e) of each of the white light emitting diodes employing the ceramic composite material for light related to Comparative Example 4 as a light converting member was a value lower than those of Examples 1 to 13. The relative value of the maximum fluorescence intensity of the ceramic composite material for light conversion related to each of Comparative Examples 3 to 6 when the maximum fluorescence intensity of the ceramic composite material for light conversion related to Comparative Example 1 was taken as 100% was defined as the relative fluorescence intensity.

[Table 1]

| | Additionally added $La_2O_3$/calcined powder (% by mass) | Fluorescence phase ($Y_3Al_5O_{12}$) /ceramic composite material for light conversion (% by mass) | $LaAl_{11}O_{18}$/light transmitting phase (% by mass) | $\alpha$-$Al_2O_3$/light transmitting phase (% by mass) | $LaAlO_3$/light transmitting phase (% by mass) | Fluorescence dominant wavelength (nm) | Internal quantum efficiency (%) | Relative fluorescence intensity (%) | Normalized luminous flux $\varphi v/B\varphi e$ |
|---|---|---|---|---|---|---|---|---|---|
| Example 1 | 1 | 58.7 | 9.0 | 91.0 | 0 | 563 | 71.6 | 102 | 0.250 |
| Example 2 | 2 | 58.9 | 18.1 | 81.9 | 0 | 562 | 73.2 | 106 | 0.269 |
| Example 3 | 3 | 59.2 | 27.3 | 72.7 | 0 | 562 | 79.8 | 114 | 0.282 |
| Example 4 | 4 | 59.4 | 36.7 | 63.3 | 0 | 561 | 80.8 | 116 | 0.282 |
| Example 5 | 5 | 59.7 | 46.2 | 53.8 | 0 | 562 | 82.1 | 118 | 0.281 |
| Example 6 | 7.5 | 60.1 | 72.8 | 27.2 | 0 | 561 | 88.7 | 129 | 0.292 |
| Example 7 | 10 | 60.4 | 100.0 | 0 | 0 | 561 | 89.6 | 130 | 0.292 |
| Example 8 | 12.5 | 58.6 | 95.7 | 0 | 4.3 | 561 | 88.9 | 130 | 0.293 |
| Example 9 | 15 | 56.8 | 91.7 | 0 | 8.3 | 561 | 80.3 | 115 | 0.278 |
| Example 10 | 17.5 | 55.0 | 88.0 | 0 | 12.0 | 562 | 80.1 | 113 | 0.269 |
| Example 11 | 20 | 54.0 | 86.9 | 0 | 13.1 | 562 | 75.8 | 115 | 0.267 |
| Example 12 | 25 | 52.0 | 83.3 | 0 | 16.7 | 561 | 70.7 | 109 | 0.259 |
| Example 13 | 30 | 50.0 | 79.9 | 0 | 20.1 | 562 | 65.9 | 107 | 0.253 |
| Comparative Example 1 | 0 | 58.4 | 0.0 | 100.0 | 0 | 563 | 64.1 | 100 | 0.234 |

[Table 2]

| | Additionally added $La_2O_3$/calcined powder (% by mass) | Fluorescence phase $(Y_3Al_5O_{12})$/ceramic composite material for light conversion (% by mass) | $LaAl_{11}O_{18}$/light transmitting phase (% by mass) | $\alpha$-$Al_2O_3$/light transmitting phase (% by mass) | $LaAlO_3$/light transmitting phase (% by mass) | Fluorescence dominant wavelength (nm) | Internal quantum efficiency (%) | Relative fluorescence intensity (%) | Normalized luminous flux $\varphi v/B\varphi e$ |
|---|---|---|---|---|---|---|---|---|---|
| Example 14 | 1 | 60.0 | 15.0 | 85.0 | 0 | 547 | 79.3 | 109 | 0.245 |
| Example 15 | 2 | 59.0 | 31.7 | 68.3 | 0 | 546 | 79.8 | 113 | 0.254 |
| Example 16 | 3 | 58.0 | 45.2 | 54.8 | 0 | 545 | 80.6 | 116 | 0.260 |
| Example 17 | 4 | 59.0 | 51.2 | 48.8 | 0 | 545 | 81.7 | 117 | 0.263 |
| Example 18 | 5 | 58.5 | 60.7 | 39.3 | 0 | 544 | 82.3 | 117 | 0.263 |
| Example 19 | 7.5 | 55.0 | 73.3 | 26.7 | 0 | 544 | 89.1 | 128 | 0.287 |
| Example 20 | 10 | 55.0 | 77.5 | 22.5 | 0 | 545 | 89.3 | 127 | 0.285 |
| Example 21 | 12.5 | 55.5 | 100.0 | 0 | 0 | 544 | 90.0 | 131 | 0.294 |
| Example 22 | 15 | 54.0 | 95.7 | 0 | 4.3 | 545 | 89.0 | 129 | 0.290 |
| Example 23 | 17.5 | 52.0 | 92.6 | 0 | 7.4 | 544 | 82.4 | 119 | 0.267 |
| Example 24 | 20 | 51.0 | 89.3 | 0 | 10.7 | 544 | 77.3 | 115 | 0.258 |
| Example 25 | 25 | 48.0 | 85.7 | 0 | 14.3 | 544 | 73.0 | 112 | 0.251 |
| Example 26 | 30 | 47.0 | 83.3 | 0 | 16.7 | 545 | 72.2 | 108 | 0.243 |
| Comparative Example 2 | 0 | 61.0 | 0 | 100.0 | 0 | 548 | 70.8 | 100 | 0.225 |

EP 3 121 246 A1

[Table 3]

| | Additionally added M-containing compound | Additionally added M-containing compound/calcined powder (% by mass) | Generated $M_xAl_yO_z$ | Fluorescence phase $(Y_3Al_5O_{12})$/ceramic composite material for light conversion (% by mass) | $M_xAl_yO_z$/light transmitting phase (% by mass) | $\alpha$-$Al_2O_3$/light transmitting phase (% by mass) | Fluorescence dominant wavelength (nm) | Internal quantum efficiency (%) | Relative fluorescence intensity (%) | Normalized luminous flux $\varphi v/B\varphi e$ |
|---|---|---|---|---|---|---|---|---|---|---|
| Comparative Example 3 | $CeO_2$ | 2.8 | $CeAl_{11}O_{18}$ | 58.7 | 20 | 80 | 569 | 67.3 | 105 | 0.230 |
| Comparative Example 4 | $CaCO_3$ | 1.1 | $CaAl_{12}O_{19}$ | 59.7 | 25.3 | 74.7 | 565 | 50.1 | 77 | 0.049 |
| Comparative Example 5 | $SrCO_3$ | 1.7 | $SrAl_{12}O_{19}$ | 59.4 | 22.6 | 77.4 | 563 | 76.2 | 119 | 0.130 |
| Comparative Example 6 | $BaCO_3$ | 1.9 | $BaAl_{12}O_{19}$ | 59.3 | 28 | 72 | 567 | 72.1 | 115 | 0.193 |

18

[Table 4]

| | Equivalent circle diameter (μm) | Fluorescence dominant wavelength (nm) | Internal quantum efficiency (%) | Relative fluorescence intensity (%) | Normalized luminous flux $\varphi v/B\varphi e$ |
|---|---|---|---|---|---|
| Example 18 | 1.40 | 544 | 82.3 | 117 | 0.263 |
| Example 21 | 3.00 | 544 | 90.0 | 131 | 0.294 |
| Comparative Example 2 | 0.83 | 548 | 70.8 | 100 | 0.225 |

(Examples 27 to 34)

Each ceramic composite material for light conversion was prepared by the same method as in Example 7, except that the ceramic composite material for light conversion obtained in Example 7 was further subjected to heat treatment under the condition of 1100 to 1700°C and for 4 hours or 8 hours in a nitrogen atmosphere or a reducing atmosphere (Ar + 4% hydrogen). The fluorescence dominant wavelength, the internal quantum efficiency, the maximum fluorescence intensity, and the normalized luminous flux of the ceramic composite material for light conversion when the ceramic composite material for light conversion was excited by light having a wavelength of 460 nm were measured by the same method as in Example 7.

It was found that the internal quantum efficiency, the relative fluorescence intensity, and the normalized luminous flux were improved by performing heat treatment in a nitrogen atmosphere or a reducing atmosphere (Ar + 4% hydrogen), and particularly when the heat treatment was performed at 1400 to 1600°C, the improvement widths thereof were increased.

[Table 5]

| | Heat treatment condition | | Fluorescence dominant wavelength (nm) | Internal quantum efficiency (%) | Relative fluorescence intensity (%) | Normalized luminous flux $\varphi v/B\varphi e$ |
|---|---|---|---|---|---|---|
| | Atmospheric gas | Temperature (°C) × time | | | | |
| Example 7 | - | - | 561 | 89.6 | 130 | 0.292 |
| Example 27 | $N_2$ | 1100°C×4h | 561 | 90.3 | 131 | 0.294 |
| Example 28 | $N_2$ | 1300°C×4h | 561 | 91.7 | 133 | 0.299 |
| Example 29 | $N_2$ | 1400°C×4h | 561 | 94.4 | 137 | 0.308 |
| Example 30 | $N_2$ | 1500°C×4h | 561 | 95.8 | 139 | 0.312 |
| Example 31 | $N_2$ | 1600°C×4h | 561 | 95.1 | 138 | 0.310 |
| Example 32 | $N_2$ | 1700°C×4h | 561 | 90.1 | 131 | 0.294 |
| Example 33 | $N_2$ | 1500°C×8h | 561 | 95.8 | 139 | 0.312 |
| Example 34 | $Ar+4\%H_2$ | 1500°C×4h | 561 | 95.8 | 139 | 0.312 |

(Example 35)

49.09 g of $\alpha$-$Al_2O_3$ powder (purity 99.99%), 24.31 g of $Y_2O_3$ powder (purity 99.9%), 2.08 g of $Gd_2O_3$ powder (purity 99. 9%), and 0.39 g of $CeO_2$ powder (purity 99.9%) were weighed respectively, these raw material powders were subjected to wet mixing in ethanol for 24 hours by a ball mill, and then the ethanol as a solvent was removed therefrom using an evaporator to obtain a mixed powder to be used in calcination. The obtained mixed powder to be used in calcination was put into an $Al_2O_3$ crucible, was charged in a batch electric furnace, and calcined while being held at 1500°C for 3 hours in an air atmosphere, thereby obtaining a calcined powder formed from $(Y_{0.95}Gd_{0.05})_3Al_5O_{12}$:Ce and $Al_2O_3$. The fact that the calcined powder was formed from $(Y_{0.95}Gd_{0.05})_3Al_5O_{12}$:Ce and $Al_2O_3$ was checked by X-ray diffraction analysis.

Next, a ceramic powder for light conversion was prepared by the same method as in Example 30, except that 11.4% by mass of $La_2O_3$ powder (purity 99.9%) with respect to 100% by mass of the calcined powder was added to the obtained calcined powder, and the mass ratio of each crystal phase in the light transmitting phase was calculated. Further, the fluorescence dominant wavelength, the internal quantum efficiency, and the maximum fluorescence intensity of the obtained ceramic composite material for light conversion when the ceramic composite material for light conversion was excited by light having a wavelength of 460 nm were measured by the same method as in Example 1.

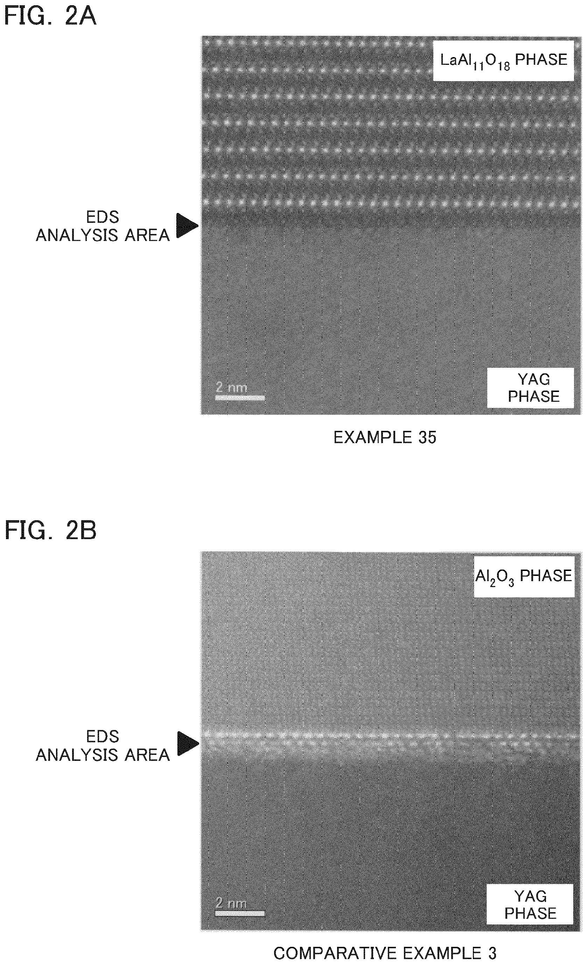

Further, the composition analysis at the interface portion between the light transmitting phase and the fluorescence phase was performed using a field emission transmission electron microscope (JEM-2100P Type manufactured by JEOL Ltd.) by EDS measurement (UTW-type Si (Li) semiconductor detector manufactured by JEOL Ltd.). FIGS. 2A and 2B show dark-field STEM photographs. In Comparative Example 7 shown in FIG. 2B to be described later, a luminescent spot in the interface portion is found, and it is found that the Ce concentration is as high as 3.9 at% as presented in Table 5. Therefore, it is found that the luminescent spot in the interface portion is a luminescent spot generated by a compound derived from Ce. On the other hand, in Example 35 shown in FIG. 2A, the luminescent spot in the interface portion is not found, and it is found that the Ce concentration is also as low as 0.3 at%. In addition, as a result of the composition analysis of the inside of the fluorescence phase, 0.14 at% of La is present and it is found that La is contained as a solid solution in the fluorescence phase.

(Comparative Example 7)

A ceramic composite material for light conversion related to Comparative Example 7 was obtained by the same method as in Example 35, except that the $La_2O_3$ powder was not additionally added to the calcined powder obtained by the same method as in Example 35 and only the calcined powder was molded. Identification and quantification of the crystal phase constituting the obtained ceramic composite material for light conversion were performed by the same method as in Example 1, and then the mass ratio of each crystal phase in the light transmitting phase was calculated. In addition, the fluorescence dominant wavelength, the internal quantum efficiency, and the maximum fluorescence intensity of the obtained ceramic composite material for light conversion when the ceramic composite material for light conversion was excited by light having a wavelength of 460 nm were measured by the same method as in Example 1. Further, the composition analysis of the interface portion between the light transmitting phase and the fluorescence phase was performed by the same method as in Example 35.

[Table 6]

| | Additionally added $La_2O_3$/calcined powder (% by mass) | Fluorescence phase ($Y_3Al_5O_{12}$)/ceramic composite material for light conversion (% by mass) | $LaAl_{11}O_{18}$/light transmitting phase (% by mass) | $\alpha$-$Al_2O_3$/light transmitting phase (% by mass) | $LaAlO_3$/light transmitting phase (% by mass) | Fluorescence dominant wavelength (nm) | Internal quantum efficiency (%) | Relative fluorescence intensity (%) | Normalized luminous flux $\varphi v/B\varphi e$ |
|---|---|---|---|---|---|---|---|---|---|
| Example 35 | 11.4 | 54.7 | 100.0 | 0.0 | 0 | 568 | 85.2 | 133 | 0.298 |
| Comparative Example 7 | 0 | 58.7 | 0.0 | 100.0 | 0 | 571 | 59.6 | 93 | 0.221 |

[Table 7]

|  | Analysis area | O (at%) | Al (at%) | Y (at%) | La (at%) | Ce (at%) | Gd (at%) |
|---|---|---|---|---|---|---|---|
| Example 35 | Interface | 45.44 | 41.83 | 8.17 | 3.51 | 0.31 | 0.74 |
| Comparative Example 7 | Interface | 54.71 | 34.62 | 6.15 | - | 3.85 | 0.68 |
| Example 35 | Fluorescence phase | 46.98 | 34.99 | 16.94 | 0.14 | 0.04 | 0.89 |
| Comparative Example 7 | Fluorescence phase | 45.87 | 35.14 | 18.01 | - | 0.09 | 0.90 |

**Claims**

1.  A ceramic composite material for light conversion comprising:

    a fluorescence phase; and
    a light transmitting phase,
    the fluorescence phase being a phase containing $Ln_3Al_5O_{12}$:Ce (Ln is at least one element selected from Y, Lu, and Tb, and Ce is an activation element), and
    the light transmitting phase being a phase containing $LaAl_{11}O_{18}$.

2.  The ceramic composite material for light conversion according to claim 1, wherein the fluorescence phase is a phase containing $(Ln,La)_3Al_5O_{12}$:Ce (Ln is at least one element selected from Y, Lu, and Tb, and Ce is an activation element).

3.  The ceramic composite material for light conversion according to claim 1 or 2, wherein the light transmitting phase is a phase containing 9 to 100% by mass of $LaAl_{11}O_{18}$.

4.  The ceramic composite material for light conversion according to claim 1 or 2, wherein the light transmitting phase is a phase further containing at least one kind selected from $\alpha$-$Al_2O_3$ and $LaAlO_3$.

5.  The ceramic composite material for light conversion according to any one of claims 1 to 4, wherein the ceramic composite material for light conversion is subjected to heat treatment at 1000 to 2000°C in an inert gas atmosphere or a reducing gas atmosphere after firing.

6.  A light emitting device comprising:

    a light emitting element; and
    the ceramic composite material for light conversion according to any one of claims 1 to 5.

7.  A light emitting device comprising:

    a light emitting element having a peak at a wavelength of 420 to 500 nm; and
    the ceramic composite material for light conversion according to any one of claims 1 to 5 emitting fluorescence which has a dominant wavelength at 540 to 580 nm.

8.  The light emitting device according to claim 6 or 7, wherein the light emitting element is a light emitting diode element.

9.  A method for producing a ceramic composite material for light conversion comprising:

    a calcining step of calcining a mixed powder containing an Al source compound, a Ln source compound (Ln is at least one element selected from Y, Lu, and Tb), and a Ce source compound; and
    a firing step of firing a La-containing mixed powder obtained by adding 1 to 50% by mass of La source compound in terms of the oxide with respect to 100% by mass of the calcined powder obtained in the calcining step.

10. The method for producing a ceramic composite material for light conversion according to claim 9, further comprising:

    a heat treatment step of performing heat treatment at 1000 to 2000°C in an inert gas atmosphere or a reducing gas atmosphere after the firing step.

**11.** The method for producing a ceramic composite material for light conversion according to claim 9 or 10, wherein the La-containing mixed powder is fired after being molded by at least one molding method selected from a press molding method, a sheet molding method, and an extrusion molding method.

FIG. 1A

EXAMPLE 21

FIG. 1B

EXAMPLE 18

FIG. 1C

COMPARATIVE EXAMPLE 2

FIG. 2A

EXAMPLE 35

FIG. 2B

COMPARATIVE EXAMPLE 3

## INTERNATIONAL SEARCH REPORT

| International application No. |
|---|
| PCT/JP2015/058010 |

**A. CLASSIFICATION OF SUBJECT MATTER**
*C09K11/08*(2006.01)i, *C04B35/50*(2006.01)i, *C04B35/653*(2006.01)i, *C09K11/80*
(2006.01)i, *H01L33/50*(2010.01)i

According to International Patent Classification (IPC) or to both national classification and IPC

**B. FIELDS SEARCHED**

Minimum documentation searched (classification system followed by classification symbols)
C09K11/08, C04B35/50, C04B35/653, C09K11/80, H01L33/50

Documentation searched other than minimum documentation to the extent that such documents are included in the fields searched
Jitsuyo Shinan Koho            1922–1996   Jitsuyo Shinan Toroku Koho   1996–2015
Kokai Jitsuyo Shinan Koho      1971–2015   Toroku Jitsuyo Shinan Koho   1994–2015

Electronic data base consulted during the international search (name of data base and, where practicable, search terms used)
CAplus/REGISTRY(STN)

**C. DOCUMENTS CONSIDERED TO BE RELEVANT**

| Category* | Citation of document, with indication, where appropriate, of the relevant passages | Relevant to claim No. |
|---|---|---|
| A | WO 2013/146994 A1 (Ube Industries, Ltd.), 03 October 2013 (03.10.2013), claims; examples 1 to 12 & EP 2832816 A1 & CN 104245881 A & TW 201402782 A | 1-11 |
| A | JP 2013-227481 A (Covalent Materials Corp.), 07 November 2013 (07.11.2013), claims; examples 1 to 75 & JP 2014-132084 A & US 2013/0256599 A1 & DE 102013202119 A1 | 1-11 |
| A | JP 2012-062459 A (Covalent Materials Corp.), 29 March 2012 (29.03.2012), claims; examples 1 to 24 & US 2012/0045634 A1 & DE 102011080832 A | 1-11 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 20 April 2015 (20.04.15) | 28 April 2015 (28.04.15) |

| Name and mailing address of the ISA/ | Authorized officer |
|---|---|
| Japan Patent Office 3-4-3,Kasumigaseki,Chiyoda-ku, Tokyo 100-8915,Japan | Telephone No. |

Form PCT/ISA/210 (second sheet) (July 2009)

**INTERNATIONAL SEARCH REPORT**

International application No.

PCT/JP2015/058010

C (Continuation). DOCUMENTS CONSIDERED TO BE RELEVANT

| Category* | Citation of document, with indication, where appropriate, of the relevant passages | Relevant to claim No. |
|---|---|---|
| A | WO 2012/081566 A1 (Ube Industries, Ltd.),<br>21 June 2012 (21.06.2012),<br>claims; examples 1 to 9<br>& JP 5354114 B2      & US 2013/0328095 A1<br>& EP 2653521 A1      & CN 103270138 A<br>& KR 10-2013-0111606 A   & TW 201231435 A | 1-11 |
| A | WO 2011/125422 A1 (Ube Industries, Ltd.),<br>13 October 2011 (13.10.2011),<br>claims; examples 1 to 9<br>& JP 5246376 B2      & US 2013/0088143 A1<br>& EP 2554627 A1      & CN 102947417 A<br>& KR 10-2012-0132575 A   & TW 201206858 A | 1-11 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000208815 A
- JP 2008041796 A
- JP 2012062459 A